# EUROPÄISCHE PATENTSCHRIFT

(11) **EP 1 134 869 B1**
(45) Veröffentlichungstag und Bekanntmachung des Hinweises auf die Patenterteilung: **06.04.2011**
(21) Anmeldenummer: 01104166.2
(22) Anmeldetag: 21.02.2001
(51) Int. Cl.: H03F 1/32, H03F 1/34

(54) **Schaltungsanordnung zur Regelung nichtlinearer Strecken**
Circuit arrangement for regulating non-linear control loops
Circuit pour le réglage des boucles de contrôle non linéaires

(30) Priorität: 16.03.2000 DE 10012863
(43) Veröffentlichungstag der Anmeldung: 19.09.2001
(73) Patentinhaber: Infineon Technologies AG, 85579 Neubiberg (DE)
(72) Erfinder: Weber, Stephan, Dr., 81739 München (DE)
(74) Vertreter: Viering, Jentschura & Partner

(56) Entgegenhaltungen:
- EP-A- 0 648 012
- EP-A- 0 818 880
- US-A- 4 549 146

## Beschreibung

Die vorliegende Erfindung betrifft eine elektronische Schaltung zur Regelung nichtlinearer Strecken.

Die Aufgabe eines Reglers besteht darin, eine physikalische Größe, die Regelgröße X, auf einen vorgegebenen Sollwert, die Führungsgröße W, zu bringen und dort zu halten. Dazu muß der Regler in geeigneter Weise dem Einfluß von Störungen entgegenwirken.

Üblicherweise weist ein einfacher Regelkreis einen Regler auf, welcher die Regelgröße X mit Hilfe einer Stellgröße Y so beeinflußt, daß die Regelabweichung W - X möglichst klein wird.

Sofern die Regelgröße durch eine elektrische Spannung repräsentiert wird, und die Strecke elektrisch gesteuert wird, können elektronische Regler verwendet werden.

Ein solcher Regler ist im einfachsten Fall ein Verstärker, der die Regelabweichung W - X verstärkt. Wenn die Regelgröße X über den Sollwert W ansteigt, wird W - X negativ. Dadurch verkleinert sich die Stellgröße Y in verstärktem Maße. Diese Abnahme wirkt der angenommenen Zunahme der Regelgröße entgegen. Somit liegt eine Gegenkopplung vor. Die im eingeschwungenen Zustand verbleibende Regelabweichung ist umso kleiner, je höher die Verstärkung des Reglers ist.

Zur Verbesserung der Einstellgenauigkeit eines ProportionalReglers, und um eine bleibende Regelabweichung von Null zu erreichen, schaltet man zu einem P-Regler einen Integrator parallel. Ein einfacher, derartiger PI-Regler verhält sich bei tiefen Frequenzen wie ein Integrator und bei hohen Frequenzen wie ein reiner Proportionalverstärker.

In der Praxis weisen Regelstrecken oft ein nichtlineares Verhalten auf. Beispielsweise Transistorverstärker oder Diodengleichrichter weisen nichtlineare Kennlinien auf. Die Übertragungskennlinien weisen oft Sättigungseffekte an den Aussteuergrenzen auf. Auch von Betriebsspannung, Eingangspegel und Temperatur werden die Übertragungskennlinien beeinflußt.

Für kleine Aussteuerungen um einen gegebenen Arbeitspunkt kann man jede Strecke als linear betrachten, wenn ihre Kennlinie in der Umgebung dieses Arbeitspunktes stetig und differenzierbar ist. Für diesen festen Arbeitspunkt kann man nunmehr den Regler optimieren. Wenn jedoch größere Änderungen der Führungsgröße W zugelassen werden sollen, treten Probleme auf: Da die differenzielle Streckenverstärkung vom Arbeitspunkt abhängig ist, ändert sich das Einschwingverhalten der Anordnung in Abhängigkeit von der Führungsgröße W. Auch die Stabilität und die Regelgenauigkeit des Reglers werden schlechter. Die Genauigkeit eines Reglers wird von der Genauigkeit des Regelgrößen-Detektors, der Verstärkung und den Offsets des Reglers beeinflußt.

In bekannter Weise läßt sich dieses Problem dadurch beseitigen, daß die Linearität der Strecke durch Vorschalten eines Funktionsnetzwerkes hergestellt wird. Wenn dieser Linearisierungsblock die inverse Kennlinie der zu linearisierenden Strecke aufweist, so ergibt sich insgesamt eine lineare Streckengleichung. Wenn die Strecke beispielsweise ein exponentielles Verhalten zeigt, wird als Funktionsnetzwerk beziehungsweise Linearisierungsblock ein Logarithmierer benötigt. Eine solche Linearisierung ist beispielsweise bekannt aus Tietze, Schenk: Halbleiter-Schaltungstechnik, 10. Auflage, 1993, Seite 951 bis 952.

Der zusätzliche Linearisierungsblock ist normalerweise temperatur- oder alterungsbedingter Drift unterworfen. Desweiteren wird die Regelung insgesamt langsamer, da der zusätzliche Linearisierungsblock selbstverständlich Laufzeiteffekte aufweist. Da der bekannte Linearisierungsblock am Ausgang des Reglers und vor der Regelstrecke angeordnet ist, fließen dort erhebliche Ströme. Desweiteren ist am Ausgang eines Regelverstärkers, welcher in einer einfachen Ausführungsform beispielsweise ein Operationsverstärker sein kann, ein beträchtlicher Spannungshub zu erwarten. An die Realisierung einer Schaltungsanordnung für einen Realisierungsblock werden somit hohe Anforderungen gestellt. Insbesondere ist ein beträchtlicher Bedarf an Chipfläche erforderlich.

In EP 0 648 012 wird ein kartesischen Verstärker beschrieben, bei welchem Verzerrungen des verstärkten Signals durch eine Rückkopplungsschleife korrigiert werden. Zudem ist dem Verstärker ein Signal-Vorprozessor vorgeschaltet, welcher Verzerrungen zwischen den Real- und Imaginärkomponenten der Signale in den unterschiedlichen Zweigen des Verstärkers ausgleicht.

Der vorliegenden Erfindung liegt die Aufgabe zugrunde, eine Schaltungsanordnung zur Regelung nichtlinearer Strecken anzugeben, welche mit geringem Aufwand realisierbar ist.

Erfindungsgemäß wird diese Aufgabe mit einer Schaltungsanordnung zur Regelung nichtlinearer Strecken gelöst, aufweisend einen Regler mit einem ersten und einem zweiten Eingang und mit einem Ausgang, an dem eine Stellgröße ableitbar ist; eine nichtlineare Regelstrecke mit einem Eingang, der mit dem Ausgang des Reglers verbunden ist, und mit einem Ausgang, an dem eine Regelgröße ableitbar ist; eine Rückführung, wobei die Rückführung einen ersten Linearisierungsblock aufweist, mit einem Eingang, der mit dem Ausgang der Regelstrecke verbunden ist, und mit einem Ausgang, der an einen Eingang des Reglers angeschlossen ist, und wobei ein zweiter Linearisierungsblock vorgesehen ist mit einem Ausgang, der an einen Eingang des Reglers angeschlossen ist, und mit einem Eingang, dem eine Führungsgröße zuführbar ist wobei der erste Linearisierungsblock und der zweite Linearisierungsblock je eine inverse Kennlinie bezüglich der Kennlinie der Regelstrecke aufweisen und der erste Linearisierunsblock und der zweite Linearisierungsblock gleich sind.

Der Schaltungsanordnung zur Regelung nichtlinearer Strecken liegt das Prinzip zugrunde, die Linearisierungsblöcke nicht am Reglerausgang anzuordnen, sondern am Reglereingang. Da an einem Reglereingang bezüglich des Ausgangs deutlich kleinere Ströme zu erwarten sind, sowie ein deutlich kleinerer Spannungshub vorherrscht, können die Linearisierungsblöcke einfacher aufgebaut sein. Außerdem sind bei geringeren zu erwartenden elektrischen Leistungen deutlich geringere Chipflächen erforderlich. Darüber hinaus ist bei kleineren Leistungen die Signalverarbeitung einfacher.

Linearisierungsblöcke, welche nichtlineare Blöcke sind, unterliegen üblicherweise einer Temperaturdrift und Toleranzen, welche beispielsweise durch die Fertigung oder die Umgebungsbedingungen bedingt sein können. Da in der beschriebenen Anordnung zwei Linearisierungsblöcke an den oder die Reglereingänge angeschlossen sind, wobei ein Linearisierungsblock in einem Rückführungszweig, und ein zweiter Linearisierungsblock an der Sollwert- beziehungsweise Führungsgrössen-Zuführung angeordnet ist, heben sich deren Temperaturdrift sowie Toleranzen gegenseitig auf.

Erfindungsgemäß bilden der erste und der zweite Linearisierungsblock je eine Umkehrfunktion der Funktion der Regelstrecke. Die Kennlinien des ersten Linearisierungsblocks beziehungsweise zweiten Linearisierungsblocks sind folglich jeweils eine inverse Kennlinie der Strecke. Die Kennlinie der Strecke kann sich dabei aus den Kennlinien mehrerer Blöcke der Strecke, beispielsweise Verstärkerstufen, zusammensetzen.

In einer weiteren, vorteilhaften Ausführungsform der vorliegenden Erfindung ist der Regler ein PI-Regler. Regler mit I-Anteil weisen eine sehr hohe statische Genauigkeit auf.

In einer vorteilhaften Ausführungsform der vorliegenden Erfindung wird der Regler mit einem einfachen Operationsverstärker realisiert. Sofern damit ein Regler mit I-Anteil realisiert werden soll, ist ein Kondensator zwischen Ausgang des
OP und invertierenden Eingang des Operationsverstärkers geschaltet.

Bei Anwendung der beschriebenen Regelung in einem Sendeverstärker auf dem Gebiet des Mobilfunks kann die Regelstrecke zwei hintereinander geschaltete Transistor-Verstärkerstufen aufweisen. Transistor-Verstärker haben üblicherweise nichtlineare Kennlinien.

Zur Erfassung der Regelgröße kann ein Detektor zwischen Ausgang der Strecke und erstem Linearisierungsblock im Rückführungszweig angeordnet sein.

Zur Kompensation von Temperaturdrift beziehungsweise Toleranzen dieses Detektors kann ein weiterer Detektor mit gleichen elektrischen Eigenschaften dem zweiten Linearisierungsblock vorgeschaltet sein. In diesem Fall ist die Führungsgröße dem weiteren Detektor zuführbar.

Zur Realisierung eines Differenzverstärkers kann der erste Linearisierungsblock, welcher in der Rückführung des Regelkreises angeordnet ist, an einen ersten Eingang des Reglers und der zweite Linearisierungsblock an einen zweiten Eingang des Reglers angeschlossen sein. Bei Verwendung eines Operationsverstärkers als Regelverstärker ist der erste Linearisierungsblock an den invertierenden, und der zweite Linearisierungsblock an den nicht-invertierenden Eingang des Operationsverstärkers anzuschließen. Ohne eine negative Rückführung ist eine Regelung nicht stabil.

In einer alternativen Anordnung kann der Operationsverstärker auch als Summierer geschaltet sein. In diesem Fall sind erster und zweiter Linearisierungsblock gemeinsam an einem Eingang des Regelverstärkers angeschlossen. Dabei kann je ein Widerstand zwischen Ausgang des Linearisierungsblockes und Eingang des Operationsverstärkers angeordnet sein.

Weitere Ausführungsformen der vorliegenden Erfindung sind in den Unteransprüchen angegeben.

Die Erfindung wird nachfolgend an zwei Ausführungsbeispielen anhand der Zeichnungen näher erläutert.

Es zeigen:
- Figur 1: ein Blockschaltbild eines ersten Ausführungsbei- spiels der vorliegenden Erfindung und
- Figur 2: ein Blockschaltbild eines zweiten Ausführungsbei- spiels der vorliegenden Erfindung.

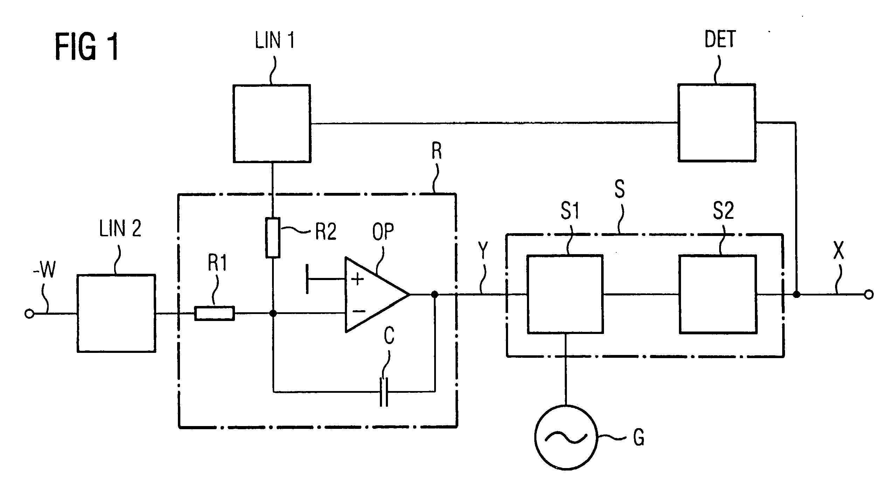

Figur 1 zeigt einen Regelkreis mit einem Regler R, einer Strecke S, und einer Rückführung. Dem Regler ist eine Führungsgröße W zuführbar. Am Ausgang der Strecke ist eine Regelgröße X ableitbar. Der Eingang der Strecke S ist mit dem Ausgang des Reglers R verbunden. An dieser Stelle liegt die Führungsgröße Y an. In einer Rückführung ist die Regelgröße X dem Regler R zuführbar.

Die Strecke S weist eine nichtlineare Kennlinie auf. Hinreichend hierfür ist, daß eine Teilstrecke S1, S2 der Strecke S eine nichtlineare Kennlinie aufweist. Zur Linearisierung der Regelstrecke S sind zwei Linearisierungsblöcke LIN1, LIN2 vorgesehen. Ein erster Linearisierungsblock LIN1 ist in der Rückführung zwischen Ausgang der Strecke S und einem Eingang des Reglers R angeordnet. Ein zweiter Linearisierungsblock LIN2 ist ebenfalls an einen Eingang des Reglers R angeschlossen. Diesem zweiten Linearisierungsblock LIN2 ist die Führungsgröße zuführbar. Zur Erfassung der Regelgröße X ist ein Detektor DET zwischen Ausgang der Strecke S und Eingang des ersten Linearisierungsblocks LIN1 angeordnet. Der Regler R weist einen Operationsverstärker OP auf, welcher zur Bildung eines Integrier-Anteils des Reglers einen Kondensator C aufweist, welcher zwischen Ausgang und invertierendem Eingang des Operationsverstärkers OP angeordnet ist. Zur Bildung eines PI-Reglers kann ein nicht eingezeichneter Widerstand in Serie zum Kondensator C geschaltet sein. Der erste Linearisierungsblock ist über einen Widerstand R2 ebenfalls an den invertierenden Eingang des Operationsverstärkers OP angeschlossen. Der nicht-invertierende Eingang des Operationsverstärkers OP ist nach Masse geschaltet. Über einen weiteren Widerstand R1 ist der zweite Linearisierungsblock LIN2 ebenfalls an den invertierenden Eingang des Operationsverstärkers OP unter Bildung eines Summierknotens mit der Rückführung angeschlossen. Damit dem Regler die Differenz aus Führungsgröße W und Regelgröße L zuführbar ist, ist an den Eingang des zweiten Linearisierungsblocks LIN2 die invertierte Führungsgröße -W anzulegen. Die Strecke S weist im vorliegenden Beispiel einen ersten Block S1 und einen nachgeschalteten, zweiten Block S2 auf. Diese können beispielsweise je eine Transistor-Verstärkerstufe repräsentieren. Ein Generator G, welcher beispielhaft lediglich an den ersten Block S1 der Strecke S angeschlossen ist, versorgt die Transistor-Verstärkerstufe S1 mit elektrischer Energie.

Durch Anordnung von zwei Linearisierungsblöcken LIN1 und LIN2, welche beispielsweise gleiche elektrische Eigenschaften aufweisen können, kompensiert sich deren Temperaturdrift gegenseitig. Ebenso werden alterungsbedingte Drifts kompensiert, ebenso wie fertigungsbedingte Toleranzen. Die nichtlineare Strecke S, deren Nichtlinearität dadurch bedingt ist, daß zumindest ein Block S1, S2 der Strecke S eine nichtlineare Kennlinie aufweist, wird in der erfindungsgemäßen Schaltung durch Anordnen eines ersten und eines zweiten Linearisierungsblocks LIN1, LIN2 linearisiert. Hierdurch ist die Regelung der nichtlinearen Regelstrecke mit einem herkömmlichen, linearen Regler möglich. Da die Linearisierungsblöcke LIN1, LIN2 eingangsseitig am Operationsverstärker OP angeordnet sind, wo üblicherweise geringe Ströme fließen und geringe Spannungshübe zu erwarten sind, und somit kleine Leistungen umgesetzt werden, können die Linearisierungsblöcke LIN1, LIN2 in einfacher Weise, mit besseren dynamischen Eigenschaften und mit geringem Bedarf an Chipfläche realisiert sein. Die dort üblicherweise umgesetzten, geringen Leistungen machen eine einfache Signalverarbeitung möglich. Wenn auch der Detektor DET eine nicht zu vernachlässigende Temperaturdrift aufweist, kann zur Kompensation dieser Temperaturdrift oder anderer Drifts ein weiterer Detektor DET dem zweiten Linearisierungsblock LIN2 vorgeschaltet sein.

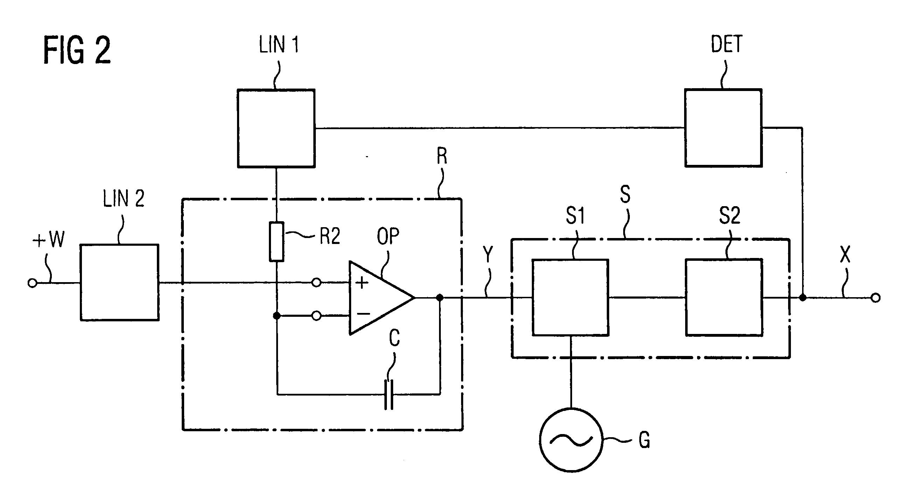

Figur 2 zeigt ein zweites Ausführungsbeispiel der vorliegenden Erfindung. Auch hier ist je ein erster Linearisierungsblock LIN1 und ein zweiter Linearisierungsblock LIN2 an einem Soll-Eingang beziehungsweise an einem Ist-Eingang des Reglers angeordnet. Abweichend vom Regler gemäß Figur 1, bei dem der Regelverstärker als Summierer geschaltet ist, ist in Figur 2 der Regler R als Differenzverstärker beschaltet. Hierzu wird die Regelgröße X mit einem Detektor DET detektiert, an den Eingang eines ersten Linearisierungsblocks LIN1 gegeben und über einen Widerstand R2 dem invertierenden Eingang des Operationsverstärkers OP zugeführt. Der nicht-invertierende Eingang des Operationsverstärkers OP ist an den Ausgang eines zweiten Linearisierungsblocks LIN2 angeschlossen. Dem Eingang des zweiten Linearisierungsblocks LIN2, dessen Ausgang mit dem nichtinvertierenden Eingang des Operationsverstärkers OP verbunden ist, ist die Führungsgröße W zuführbar. Hierbei braucht die Führungsgröße W nicht invertiert zugeführt werden, da die Differenz von Führungsgröße W und Regelgröße X durch Beschaltung des Operationsverstärkers OP als Differenzverstärker gewährleistet ist. Die übrige Schaltungsanordnung gemäß Figur 2 ist wie in Figur 1 dargestellt ausgeführt. Die Vorteile der beschriebenen Schaltungsanordnung bleiben dabei erhalten.

Als Regler R können auch andere als der gezeigte I- beziehungsweise PI-Regler eingesetzt werden. Das erfindungsgemäße Prinzip der Anordnung zweier Linearisierungsblöcke LIN1, LIN2 zur Zuführung von Regelgröße X beziehungsweise Führungsgröße W an den Regler R bleibt hierbei erhalten.

## Patentansprüche

1. Schaltungsanordnung zur Regelung nichtlinearer Strecken, aufweisend
- einen Regler (R) mit einem ersten Eingang, einem zweiten Eingang und mit einem Ausgang, an dem eine Stellgröße (Y) ableitbar ist,
- eine nichtlineare Regelstrecke (S) mit einem Eingang, der mit dem Ausgang des Reglers verbunden ist, und mit einem Ausgang, an dem eine Regelgröße (X) ableitbar ist,
eine Rückführung,
**dadurch gekennzeichnet, dass**
die Rückführung einen ersten Linearisierungsblock (LIN1) aufweist, mit einem Eingang, der mit dem Ausgang der Regelstrecke (S) verbunden ist, und mit einem Ausgang, der an einen Eingang des Reglers (R) angeschlossen ist, und dass ein zweiter Linearisierungsblock (LIN2) vorgesehen ist, mit einem Ausgang, der an einen Eingang des Reglers (R) angeschlossen ist, und mit einem Eingang, dem eine Führungsgröße (W) zuführbar ist, wobei der erste Linearisierungsblock (LIN1) und der zweite Linearisierungsblock (LIN2) je eine inverse Kennlinie bezüglich der Kennlinie der Regelstrecke (S) aufweisen und der erste Linearisierunsblock (LIN1) und der zweite Linearisierungsblock (LIN2) gleich sind.

2. Schaltungsanordnung nach Anspruch 1,
**dadurch gekennzeichnet, dass**
der Regler (R) ein PI-Regler ist.

3. Schaltungsanordnung nach einem der Ansprüche 1 oder 2,
**dadurch gekennzeichnet, dass**
der Regler (R) ein Operationsverstärker (OP) mit einem invertierenden und einem nicht-invertierenden Eingang und mit einem Ausgang ist, wobei ein Kondensator (C) zwischen Ausgang
und invertierendem Eingang des Operationsverstärkers (OP) geschaltet ist.

4. Schaltungsanordnung nach einem der Ansprüche 1 bis 3,
**dadurch gekennzeichnet, dass**
die Regelstrecke (S) zwei hintereinander geschaltete Transistor-Verstärkerstufen (S1, S2) aufweist.

5. Schaltungsanordnung nach einem der Ansprüche 1 bis 4,
**dadurch gekennzeichnet, dass**
zur Erfassung der Regelgröße (X) ein Detektor (DET) zwischen Ausgang der Regelstrecke (S) und ersten Linearisierungsblock (LIN1) geschaltet ist.

6. Schaltungsanordnung nach Anspruch 5,
**dadurch gekennzeichnet, dass**
an dem Eingang des zweiten Linearisierungsblocks (LIN2) ein weiterer Detektor angeschlossen ist, dem die Führungsgröße (W) zuführbar ist.

7. Schaltungsanordnung nach einem der Ansprüche 1 bis 6,
**dadurch gekennzeichnet, dass**
der erste Linearisierungsblock (LIN1) an einem ersten und der zweite Linearisierungsblock (LIN2) an einem zweiten Eingang des Reglers (R) angeschlossen ist.

## Claims

1. Circuit arrangement for controlling non-linear paths, comprising
- a controller (R) having a first input, a second input and an output, at which a correcting variable (Y) is derivable,
- a non-linear control path (S) having an input, which is coupled to the output of the controller, and having an output, at which a control variable (X) is derivable,
- a feedback path,
**characterized in that**
the feedback path comprises a first linearising block (LIN1), having an input, which is coupled to the output of the control path (S), and having an output, which is coupled to an input of the controller (R), and that a second linearising block (LIN2) is provided, having an output, which is coupled to an input of the controller (R), and having an input, to which a command variable (W) can be supplied, wherein the first linearising block (LIN1) and the second linearising block (LIN2) each comprise an inverse characteristic curve with respect to the characteristic curve of the control path (S) and the first linearising block (LIN1) and the second linearising block (LIN2) are equal.

2. Circuit arrangement according to claim 1,
**characterized in that**
the controller (R) is a PI-controller.

3. Circuit arrangement according to any one of claims 1 or 2,
**characterized in that**
the controller (R) is an operational amplifier (OP) having an inverting and a non-inverting input and an output, wherein a capacitor (C) is connected between the output and the inverting input of the operational amplifier (OP).

4. Circuit arrangement according to any one of claims 1 to 3,
**characterized in that**
the control path (S) comprises two serially connected transistor amplifier stages (S1, S2).

5. Circuit arrangement according to any one of claims 1 to 4,
**characterized in that**
a detector (DET) is connected between the output of the control path (S) and the first linearising block (LIN1) for detecting the control variable (X).

6. Circuit arrangement according to claim 5,
**characterized in that**
a further detector is connected to the input of the second linearising block (LIN2), to which further detector the command variable (W) can be supplied.

7. Circuit arrangement according to any one of claims 1 to 6,
**characterized in that**
the first linearising block (LIN1) is connected to a first input of the controller (R) and the second linearising block (LIN2) is connected to the second input of the controller (R).

## Revendications

1. Montage de régulation de boucles de régulation non linéaires, comportant
- un régulateur (R) ayant une première entrée et une deuxième entrée et une sortie, de laquelle une grandeur (Y) réglante peut être déduite,
- une boucle (S) de régulation non linéaire ayant une entrée, qui est reliée à la sortie du régulateur, et ayant une sortie, de laquelle peut être dérivée une grandeur (X) réglante,
une réaction,
**caractérisé en ce que**
la réaction à un premier bloc (LIN1) de linéarisation, ayant une entrée, qui est reliée à la sortie de la boucle (S) de régulation, et ayant une sortie, qui est raccordée à une entrée du régulateur (R), et **en ce qu'**il est prévu un deuxième bloc (LIN2) de linéarisation, ayant une sortie, qui est raccordée à une entrée du régulateur (R), et ayant une entrée, à laquelle peut être envoyée une grandeur (W) de conduite, le premier bloc (LIN1) de linéarisation et le deuxième bloc (LIN2) de linéarisation ayant respectivement une caractéristique inverse en ce qui concerne la caractéristique de la boucle (S) de régulation et le premier bloc (LIN1) de linéarisation et le deuxième bloc (LIN2) de linéarisation étant identiques.

2. Montage suivant la revendication 1,
**caractérisé en ce que**
le régulateur (R) est un régulateur PI.

3. Montage suivant l'une des revendications 1 ou 2,
**caractérisé en ce que**
le régulateur (R) est un amplificateur (OP) opérationnel ayant une entrée inverseuse et une entrée non inverseuse ayant une sortie, un condensateur (C) étant monté entre une sortie et une entrée inverseuse de l'amplificateur (OP) opérationnel.

4. Montage suivant l'une des revendications 1 à 3,
**caractérisé en ce que**
la boucle (S) de régulation a deux étages (S1, S2) amplificateurs à transistor montés l'un derrière l'autre.

5. Montage suivant l'une des revendications 1 à 4,
**caractérisé en ce que**
pour relever la grandeur (X) réglante, un détecteur (DET) est monté entre la sortie de la boucle (S) de régulation et le premier bloc (LIN1) de linéarisation.

6. Montage suivant la revendication 5,
**caractérisé en ce que**
à l'entrée du deuxième bloc (LIN2) de linéarisation est raccordé un autre détecteur, auquel la grandeur (W) de conduite peut être envoyée.

7. Montage suivant l'une des revendications 1 à 6,
**caractérisé en ce que**
le premier bloc (LIN1) de linéarisation est raccordé à une première entrée du régulateur (R) et le deuxième bloc (LIN2) de linéarisation est raccordé à une deuxième entrée du régulateur (R).
